# EUROPEAN PATENT APPLICATION

(11) **EP 4 545 813 A1**
(43) Date of publication of application: **30.04.2025**
(21) Application number: 23909368.5
(22) Date of filing: 19.09.2023
(51) Int. Cl.: F16C 11/04, G09F 9/30, F16C 11/10

(54) **FOLDABLE ELECTRONIC DEVICE AND ROTATING SHAFT MECHANISM THEREOF**

(30) Priority: 27.12.2022 CN 202211684261
(71) Applicant: Huawei Technologies Co., Ltd., Shenzhen, Guangdong 518129 (CN)
(72) Inventor: WU, Weifeng, Shenzhen, Guangdong 518129 (CN); ZHONG, Ding, Shenzhen, Guangdong 518129 (CN); ZHAN, Qiang, Shenzhen, Guangdong 518129 (CN); ZHAO, Jiaxin, Shenzhen, Guangdong 518129 (CN); HUA, Leilei, Shenzhen, Guangdong 518129 (CN)
(74) Representative: MERH-IP Matias Erny Reichl Hoffmann Patentanwälte PartG mbB
(86) International application number: PCT/CN2023/119684
(87) International publication number: WO 2024/139433

(57) **Abstract**

A foldable electronic device and a hinge mechanism (1) thereof are provided. In addition to the hinge mechanism (1), the electronic device further includes two housings (2 and 3) and a flexible display (4). The two housings (2 and 3) are respectively disposed on two opposite sides of the hinge mechanism (1) and are rotatably connected to the hinge mechanism (1). The hinge mechanism (1) includes a base (1011) and a main shaft module (101). The base (1011) includes a bearing surface (10111). The main shaft module (101) includes two rotating assemblies (1012 and 1013). The two rotating assemblies (1012 and 1013) are disposed on two opposite sides of the base (1011). Each rotating assembly (1012 or 1013) includes a swing arm (10121 or 10131) and a housing fastening bracket (10123 or 10133), and each housing fastening bracket (10123 or 10133) may be fastened to a housing (2 or 3) on a corresponding side. In an unfolded state, the bearing surface (10111) independently supports a foldable portion of the flexible display (4). In a folded state, a screen accommodation space (5) for accommodating the foldable portion of the flexible display (4) is formed between the two housing fastening brackets (10123 and 10133) and the base (1011).

## Description

### CROSS-REFERENCE TO RELATED APPLICATIONS

This application claims priority to Chinese Patent Application No. 202211684261.0, filed with the China National Intellectual Property Administration on December 27, 2022 and entitled "FOLDABLE ELECTRONIC DEVICE AND HINGE MECHANISM THEREOF", which is incorporated herein by reference in its entirety.

### TECHNICAL FIELD

This application relates to the field of electronic device technologies, and in particular, to a foldable electronic device and a hinge mechanism thereof.

### BACKGROUND

As flexible display technologies gradually mature, display manners of electronic devices are driven to change greatly. A mobile phone having a foldable flexible display, a tablet computer having a foldable flexible display, a wearable electronic device having a foldable flexible display, and the like are an important evolution direction of intelligent electronic devices in the future.

A flexible display is a key component of a foldable electronic device, and has a feature of being continuously foldable. As a core mechanism for implementing a folding function of the foldable electronic device, a hinge mechanism needs to support the flexible display in an unfolded state, and further needs to have a capability of accommodating the flexible display in a folded state. Based on this, a solution of three-door plate support or double-door plate support is usually used in a current hinge mechanism. Consequently, a structure of a support member of the hinge mechanism is complex, and manufacturing costs are high. In addition, there are a large quantity of step differences between components, affecting flatness of an unfolded support surface of the hinge mechanism in an unfolded state, and therefore affecting light and shadow effect of the flexible display.

Therefore, in the field of foldable electronic device products, a hinge mechanism that can improve light and shadow effect of a flexible display is urgently needed, to improve user experience, thereby improving product competitiveness.

### SUMMARY

This application provides a foldable electronic device and a hinge mechanism thereof, to improve light and shadow effect of a flexible display of the foldable electronic device, thereby improving user experience and improving product competitiveness of the electronic device.

According to a first aspect, this application provides an electronic device. The electronic device includes a first housing, a second housing, a hinge mechanism, and a flexible display. The first housing and the second housing are respectively disposed on two opposite sides of the hinge mechanism, and the first housing and the second housing are rotatably connected to the hinge mechanism. The flexible display may continuously cover the first housing, the second housing, and the hinge mechanism, and the flexible display is fastened to the first housing and the second housing. The hinge mechanism may include a base and a main shaft module. The base may include a bearing surface, and the bearing surface is disposed toward the flexible display. The main shaft module may include a first rotating assembly and a second rotating assembly, and the first rotating assembly and the second rotating assembly are disposed on two opposite sides of the base. During specific arrangement of the first rotating assembly, the first rotating assembly may include a first swing arm and a first housing fastening bracket, the first swing arm has a first plate surface, and the first plate surface is disposed toward the flexible display. In addition, the first swing arm is rotatably connected to the base, the first swing arm is slidably connected to the first housing fastening bracket, and the first housing fastening bracket is fastened to the first housing. Similarly, the second rotating assembly may include a second swing arm and a second housing fastening bracket, the second swing arm has a second plate surface, and the second plate surface is disposed toward the flexible display. In addition, the second swing arm is rotatably connected to the base, the second swing arm is slidably connected to the second housing fastening bracket, and the second housing fastening bracket is fastened to the first housing. In this way, when the electronic device is in an unfolded state, the bearing surface of the base, the first plate surface of the first swing arm, and the second plate surface of the second swing arm may support a foldable portion of the flexible display. This can effectively improve flatness of the foldable portion of the flexible display, thereby improving light and shadow effect of the flexible display and improving user experience. In addition, a structure of the hinge mechanism may be further simplified, so that a structure of the electronic device may be simplified, to reduce processing costs of the electronic device. When the electronic device is in a folded state, a screen accommodation space may be formed between the first housing fastening bracket, the second housing fastening bracket, and the base, and a foldable portion of the flexible display may be accommodated in the screen accommodation space. This can avoid squeezing of the foldable portion of the flexible display, thereby improving structural reliability of the flexible display and prolonging a service life of the flexible display.

It may be understood that, in order to enable the hinge mechanism to provide flat support for the foldable portion of the flexible display when the electronic device is in the unfolded state, in a possible implementation of this application, the bearing surface, the first plate surface, and the second plate surface may be made flush with each other when the electronic device is in the unfolded state, so that a complete support plane may be formed between the bearing surface, the first plate surface, and the second plate surface. This helps improve the flatness of the foldable portion of the flexible display in this state.

In addition, because the flexible display may be fastened to the first housing and the second housing, to provide flat support for the flexible display, the first housing may include a first support surface, and the first support surface is a surface that is of the first housing and that is configured to support the flexible display. In addition, the first housing fastening bracket has a first surface, and the first surface is disposed toward the flexible display. Similarly, the second housing may include a second support surface, and the second support surface is a surface that is of the second housing and that is configured to support the flexible display. In addition, the second housing fastening bracket has a third surface, and the third surface is disposed toward the flexible display. In this way, the first support surface may be flush with the first surface, and the second support surface may be flush with the third surface, to reduce step differences between planes for supporting the flexible display, and improve flatness of the flexible display when the electronic device is in the unfolded state.

In a possible implementation of this application, the first rotating assembly further includes a first support arm, the first support arm is rotatably connected to the base, and a rotation axis of the first support arm does not coincide with a rotation axis of the first swing arm. Similarly, the second rotating assembly further includes a second support arm, the second support arm is rotatably connected to the base, and a rotation axis of the second support arm does not coincide with a rotation axis of the second swing arm. In this way, in a rotation process of the hinge mechanism, an axis center phase difference between a support arm and a swing arm that are disposed on a same side can be implemented, to implement telescopic movement of two rotating assemblies, so that the hinge mechanism can provide stable support for the flexible display of the electronic device when the hinge mechanism is in an unfolded state, and a water drop-like screen accommodation space that meets a folding requirement of the flexible display can be formed when the hinge mechanism is in a folded state.

In addition, a first sliding groove extending in a first direction and a second sliding groove extending in a second direction are provided on the first housing fastening bracket. In this way, the first support arm may slide in the first sliding groove in the first direction, and the first swing arm may slide in the second sliding groove. A projection of the first direction onto a first cross section is not parallel to a projection of the second direction onto the first cross section. The first cross section is a reference plane perpendicular to the rotation axis of the first support arm and the rotation axis of the first swing arm. Similarly, a third sliding groove extending in a third direction and a fourth sliding groove extending in a fourth direction are provided on the second housing fastening bracket. In this way, the second support arm may slide in the third sliding groove, and the third swing arm may slide in the fourth sliding groove. A projection of the third direction onto a second cross section is not parallel to a projection of the fourth direction onto the second cross section. The second cross section is a reference plane perpendicular to the rotation axis of the second support arm and the rotation axis of the second swing arm. In this application, opening directions of the first sliding groove and the second sliding groove of the first housing fastening bracket are appropriately designed, so that rotation angles of the first support arm and the first swing arm relative to the base may be adjusted. For example, the rotation angles of the first support arm and the first swing arm relative to the base can be neither greater than 90°. Similarly, opening directions of the third sliding groove and the fourth sliding groove of the second housing fastening bracket are appropriately designed, so that rotation angles of the second support arm and the second swing arm relative to the base may be adjusted. For example, the rotation angles of the second support arm and the second swing arm relative to the base can be neither greater than 90°. In this way, rotation angles of the first swing arm and the second swing arm relative to the base may be small, so that another structure of the hinge mechanism may be prevented from avoiding rotation of the first swing arm and the second swing arm. This may help increase wall thicknesses of partial structures of the first swing arm and the second swing arm, thereby improving structural reliability of the first swing arm and the second swing arm.

In a possible implementation of this application, the main shaft module may further include a synchronization assembly, and the synchronization assembly may include a first gear and a second gear that are engaged with each other. The first gear is fastened to an end of the first support arm, and the second gear is fastened to an end of the second support arm. In addition, the first gear and the first support arm rotate coaxially, and the second gear and the second support arm rotate coaxially. In this way, when one support arm rotates around the base, the other support arm can be driven to synchronously rotate toward or away from the support arm at a same angle. In addition, because two support arms are separately slidably connected to a housing fastening bracket on a same side of the base, synchronous rotation of two housing fastening brackets may be implemented through synchronous rotation of the two support arms. In addition, in the electronic device, the two housing fastening brackets may be separately fastened to one housing, so that two housings of the electronic device can synchronously rotate. This can avoid applying an instantaneous acting force to the flexible display fastened to the two housings, thereby helping improve reliability of the flexible display.

In addition to being disposed on the first support arm, the first gear may also be disposed on the first swing arm. Similarly, the second gear may also be disposed on the second swing arm. In this way, the first swing arm and the second swing arm may synchronously rotate toward or away from each other at a same angle, to implement synchronous rotation of the two housing fastening brackets, thereby implementing synchronous rotation of the two housings.

In addition, the synchronization assembly may further include an even number of driven gears, and the even number of driven gears may be disposed between the first gear and the second gear, so that the first gear and the second gear synchronously rotate by using the even number of driven gears. This helps improve movement stability of the synchronization assembly, to improve reliability of synchronous rotation of the two support arms or two swing arms.

In addition to the foregoing structures, a damping assembly may be further disposed in the main shaft module. The damping assembly may include an elastic assembly and a first conjoined cam. The first conjoined cam may be located between the elastic assembly and the first support arm, and the first conjoined cam may be located between the elastic assembly and the second support arm. The elastic assembly may press the first conjoined cam toward the first gear and the second gear. In addition, a first cam structure may be disposed at an end portion of the first gear in an extension direction of a rotation axis of the first gear. A second cam structure may be disposed at an end portion of the second support arm in an extension direction of a rotation axis of the second gear. A third cam structure may be disposed at an end portion that is of the first conjoined cam and that faces the first gear. A fourth cam structure may be disposed at an end portion that is of the first conjoined cam and that faces the second gear. Under an action of an elastic force of the elastic assembly, the first cam structure and the third cam structure that correspond to each other abut against each other, and the second cam structure and the fourth cam structure that correspond to each other abut against each other. In this way, in a process in which the two support arms rotate around the base, damping forces may be generated between cam structures that cooperate with each other, and the damping force blocks rotation of a support arm on a corresponding side. The damping forces may be transferred to housing fastening brackets on corresponding sides by using the two support arms, so that the damping forces act on the housings of the electronic device by using the housing fastening brackets. This can avoid false unfolding and folding of the electronic device, and can implement suspension of the two housings at specified positions. In addition, a user may have an obvious feeling in a process of unfolding or folding the electronic device. This helps improve user experience.

To increase a damping force provided by the damping assembly, in this application, the damping assembly may further include a second conjoined cam, and the elastic assembly is located between the first conjoined cam and the second conjoined cam. In addition, the synchronization assembly may further include a third gear and a fourth gear. The third gear and the fourth gear are engaged with each other, and the third gear and the fourth gear are located on a side that is of the second conjoined cam and that is away from the elastic assembly. A fifth cam structure is disposed at an end portion that is of the third gear and that faces the second conjoined cam. A sixth cam structure is disposed at an end portion that is of the second gear and that faces the second conjoined cam. The second conjoined cam includes a seventh cam structure and an eighth cam structure. Under the action of the elastic force of the elastic assembly, the seventh cam structure abuts against the fifth cam structure, and the eighth cam structure abuts against the sixth cam structure.

In this application, to implement a rotatable connection between the first swing arm and the base, a first arc-shaped rotating block may be disposed at an end that is of the first swing arm and that is used for the rotatable connection to the base, and the base has a first arc-shaped groove. In this way, the first arc-shaped rotating block may rotate along an arc-shaped surface of the first arc-shaped groove, to implement the rotatable connection between the first swing arm and the base. Similarly, a second arc-shaped rotating block is disposed at an end that is of the second swing arm and that is used for a rotatable connection to the base, and the base has a second arc-shaped groove. In this way, the second arc-shaped rotating block may rotate along an arc-shaped surface of the second arc-shaped groove, to implement the rotatable connection between the second swing arm and the base. The first swing arm and the second swing arm are rotatably connected to the base through virtual shafts, so that a size of the hinge mechanism can be effectively reduced, thereby facilitating implementation of a miniaturization design of the electronic device.

According to a second aspect, this application further provides a hinge mechanism. The hinge mechanism may be used in a foldable electronic device, and the hinge mechanism is disposed corresponding to a foldable portion of a flexible display of the electronic device. During specific arrangement of the hinge mechanism, the hinge mechanism may include a base and a main shaft module. The base includes a bearing surface, and the bearing surface is disposed toward the flexible display. The main shaft module may include a first rotating assembly and a second rotating assembly, and the first rotating assembly and the second rotating assembly are respectively disposed on two opposite sides of the base. During specific arrangement of the first rotating assembly, the first rotating assembly may include a first swing arm and a first housing fastening bracket, the first swing arm has a first plate surface, and the first plate surface is disposed toward the flexible display. In addition, the first swing arm is rotatably connected to the base, the first swing arm is slidably connected to the first housing fastening bracket, and the first housing fastening bracket is fastened to a first housing. Similarly, the second rotating assembly may include a second swing arm and a second housing fastening bracket, the second swing arm has a second plate surface, and the second plate surface is disposed toward the flexible display. In addition, the second swing arm is rotatably connected to the base, the second swing arm is slidably connected to the second housing fastening bracket, and the second housing fastening bracket is fastened to the first housing. In this way, when the hinge mechanism is in an unfolded state, the bearing surface of the base, the first plate surface of the first swing arm, and the second plate surface of the second swing arm may support a foldable portion of the flexible display. This can effectively improve flatness of the foldable portion of the flexible display, thereby improving light and shadow effect of the flexible display and improving user experience. In addition, a structure of the hinge mechanism may be further simplified, so that a structure of the electronic device may be simplified, to reduce processing costs of the electronic device. When the hinge mechanism is in a folded state, a screen accommodation space may be formed between the first housing fastening bracket, the second housing fastening bracket, and the base, and a foldable portion of the flexible display may be accommodated in the screen accommodation space. This can avoid squeezing of the foldable portion of the flexible display, thereby improving structural reliability of the flexible display and prolonging a service life of the flexible display.

It may be understood that, in order to enable the hinge mechanism to provide flat support for the foldable portion of the flexible display when the hinge mechanism is in the unfolded state, in a possible implementation of this application, the bearing surface, the first plate surface, and the second plate surface may be made flush with each other when the hinge mechanism is in the unfolded state, so that a complete support plane may be formed between the bearing surface, the first plate surface, and the second plate surface. This helps improve the flatness of the foldable portion of the flexible display in this state.

In addition, in this application, the first housing fastening bracket has a first surface, and the first surface is disposed toward the flexible display. Similarly, the second housing fastening bracket has a third surface, and the third surface is disposed toward the flexible display. In this way, the first surface, the third surface, and the bearing surface may be flush with each other, to reduce step differences between components that are disposed corresponding to the foldable portion the flexible display for supporting, so that when the electronic device in which the hinge mechanism is used is in an unfolded state, flatness of the flexible display may be improved.

In a possible implementation of this application, the first rotating assembly further includes a first support arm, the first support arm is rotatably connected to the base, and a rotation axis of the first support arm does not coincide with a rotation axis of the first swing arm. Similarly, the second rotating assembly further includes a second support arm, the second support arm is rotatably connected to the base, and a rotation axis of the second support arm does not coincide with a rotation axis of the second swing arm. In this way, in a rotation process of the hinge mechanism, an axis center phase difference between a support arm and a swing arm that are disposed on a same side can be implemented, to implement telescopic movement of two rotating assemblies, so that the hinge mechanism can provide stable support for the flexible display of the electronic device when the hinge mechanism is in the unfolded state, and a water drop-like screen accommodation space that meets a folding requirement of the flexible display can be formed when the hinge mechanism is in the folded state.

In addition, a first sliding groove extending in a first direction and a second sliding groove extending in a second direction are provided on the first housing fastening bracket. In this way, the first support arm may slide in the first sliding groove in the first direction, and the first swing arm may slide in the second sliding groove. A projection of the first direction onto a first cross section is not parallel to a projection of the second direction onto the first cross section. The first cross section is a reference plane perpendicular to the rotation axis of the first support arm and the rotation axis of the first swing arm. Similarly, a third sliding groove extending in a third direction and a fourth sliding groove extending in a fourth direction are provided on the second housing fastening bracket. In this way, the second support arm may slide in the third sliding groove, and the third swing arm may slide in the fourth sliding groove. A projection of the third direction onto a second cross section is not parallel to a projection of the fourth direction onto the second cross section. The second cross section is a reference plane perpendicular to the rotation axis of the second support arm and the rotation axis of the second swing arm. In this application, opening directions of the first sliding groove and the second sliding groove of the first housing fastening bracket are appropriately designed, so that rotation angles of the first support arm and the first swing arm relative to the base may be adjusted. For example, the rotation angles of the first support arm and the first swing arm relative to the base can be neither greater than 90°. Similarly, opening directions of the third sliding groove and the fourth sliding groove of the second housing fastening bracket are appropriately designed, so that rotation angles of the second support arm and the second swing arm relative to the base may be adjusted. For example, the rotation angles of the second support arm and the second swing arm relative to the base can be neither greater than 90°. In this way, rotation angles of the first swing arm and the second swing arm relative to the base may be small, so that another structure of the hinge mechanism may be prevented from avoiding rotation of the first swing arm and the second swing arm. This may help increase wall thicknesses of partial structures of the first swing arm and the second swing arm, thereby improving structural reliability of the first swing arm and the second swing arm.

In a possible implementation of this application, the main shaft module may further include a synchronization assembly, and the synchronization assembly may include a first gear and a second gear that are engaged with each other. The first gear is fastened to an end of the first support arm, and the second gear is fastened to an end of the second support arm. In addition, the first gear and the first support arm rotate coaxially, and the second gear and the second support arm rotate coaxially. In this way, when one support arm rotates around the base, the other support arm can be driven to synchronously rotate toward or away from the support arm at a same angle. In addition, because two support arms are separately slidably connected to a housing fastening bracket on a same side of the base, synchronous rotation of two housing fastening brackets may be implemented through synchronous rotation of the two support arms. In addition, in the electronic device, the two housing fastening brackets may be separately fastened to one housing, so that two housings of the electronic device can synchronously rotate. This can avoid applying an instantaneous acting force to the flexible display fastened to the two housings, thereby helping improve reliability of the flexible display.

In addition to being disposed on the first support arm, the first gear may also be disposed on the first swing arm. Similarly, the second gear may also be disposed on the second swing arm. In this way, the first swing arm and the second swing arm may synchronously rotate toward or away from each other at a same angle, to implement synchronous rotation of the two housing fastening brackets, thereby implementing synchronous rotation of the two housings.

In addition, the synchronization assembly may further include an even number of driven gears, and the even number of driven gears may be disposed between the first gear and the second gear, so that the first gear and the second gear synchronously rotate by using the even number of driven gears. This helps improve movement stability of the synchronization assembly, to improve reliability of synchronous rotation of the two support arms or two swing arms.

In addition to the foregoing structures, a damping assembly may be further disposed in the main shaft module. The damping assembly may include an elastic assembly and a first conjoined cam. The first conjoined cam may be located between the elastic assembly and the first support arm, and the first conjoined cam may be located between the elastic assembly and the second support arm. The elastic assembly may press the first conjoined cam toward the first gear and the second gear. In addition, a first cam structure may be disposed at an end portion of the first gear in an extension direction of a rotation axis of the first gear. A second cam structure may be disposed at an end portion of the second support arm in an extension direction of a rotation axis of the second gear. A third cam structure may be disposed at an end portion that is of the first conjoined cam and that faces the first gear. A fourth cam structure may be disposed at an end portion that is of the first conjoined cam and that faces the second gear. Under an action of an elastic force of the elastic assembly, the first cam structure and the third cam structure that correspond to each other abut against each other, and the second cam structure and the fourth cam structure that correspond to each other abut against each other. In this way, in a process in which the two support arms rotate around the base, damping forces may be generated between cam structures that cooperate with each other, and the damping force blocks rotation of a support arm on a corresponding side. The damping forces may be transferred to housing fastening brackets on corresponding sides by using the two support arms, so that the damping forces act on the housings of the electronic device by using the housing fastening brackets. This can avoid false unfolding and folding of the electronic device, and can implement suspension of the two housings at specified positions. In addition, a user may have an obvious feeling in a process of unfolding or folding the electronic device. This helps improve user experience.

To increase a damping force provided by the damping assembly, in this application, the damping assembly may further include a second conjoined cam, and the elastic assembly is located between the first conjoined cam and the second conjoined cam. In addition, the synchronization assembly may further include a third gear and a fourth gear. The third gear and the fourth gear are engaged with each other, and the third gear and the fourth gear are located on a side that is of the second conjoined cam and that is away from the elastic assembly. A fifth cam structure is disposed at an end portion that is of the third gear and that faces the second conjoined cam. A sixth cam structure is disposed at an end portion that is of the second gear and that faces the second conjoined cam. The second conjoined cam includes a seventh cam structure and an eighth cam structure. Under the action of the elastic force of the elastic assembly, the seventh cam structure abuts against the fifth cam structure, and the eighth cam structure abuts against the sixth cam structure.

In this application, to implement a rotatable connection between the first swing arm and the base, a first arc-shaped rotating block may be disposed at an end that is of the first swing arm and that is used for the rotatable connection to the base, and the base has a first arc-shaped groove. In this way, the first arc-shaped rotating block may rotate along an arc-shaped surface of the first arc-shaped groove, to implement the rotatable connection between the first swing arm and the base. Similarly, a second arc-shaped rotating block is disposed at an end that is of the second swing arm and that is used for a rotatable connection to the base, and the base has a second arc-shaped groove. In this way, the second arc-shaped rotating block may rotate along an arc-shaped surface of the second arc-shaped groove, to implement the rotatable connection between the second swing arm and the base. The first swing arm and the second swing arm are rotatably connected to the base through virtual shafts, so that a size of the hinge mechanism can be effectively reduced, thereby facilitating implementation of a miniaturization design of the electronic device in which the hinge mechanism is used.

### BRIEF DESCRIPTION OF DRAWINGS

FIG. 1 is a diagram of a structure of an electronic device in a folded state according to an embodiment of this application;
FIG. 2 is a diagram of a structure of an electronic device in an unfolded state according to an embodiment of this application;
FIG. 3 is a schematic exploded view of a structure of a hinge mechanism of the electronic device shown in FIG. 2;
FIG. 4 is a diagram of a partial structure of a hinge mechanism according to an embodiment of this application;
FIG. 5 is an A-direction view of the hinge mechanism shown in FIG. 4;
FIG. 6 is a schematic exploded view of a structure of the hinge mechanism shown in FIG. 4;
FIG. 7 is a diagram of a structure of a first swing arm according to an embodiment of this application;
FIG. 8 is a diagram of a partial structure of a base according to an embodiment of this application;
FIG. 9 is a diagram of a structure in which a base supports a flexible display in an unfolded state according to an embodiment of this application;
FIG. 10a is a diagram of a partial structure of the hinge mechanism shown in FIG. 4;
FIG. 10b is a diagram of a first cross section according to an embodiment of this application;
FIG. 11 is a diagram of a structure of a hinge mechanism of an electronic device in an intermediate state according to an embodiment of this application;
FIG. 12 is a diagram of a structure of a hinge mechanism of an electronic device in a folded state according to an embodiment of this application;
FIG. 13 is a cross-sectional view of the hinge mechanism in FIG. 12 at a first swing arm and a second swing arm;
FIG. 14 is a diagram of a partial structure of a hinge mechanism of an electronic device according to an embodiment of this application;
FIG. 15 is a diagram of a structure in which a base supports a flexible display in a folded state according to an embodiment of this application;
FIG. 16 is a diagram of a principle of a mechanism in which a support arm and a swing arm slide relative to a housing fastening bracket according to an embodiment of this application;
FIG. 17 is a diagram of a structure of a hinge mechanism according to an embodiment of this application;
FIG. 18 is a B-B cross-sectional view of the hinge mechanism shown in FIG. 17; and
FIG. 19 is a cross-sectional view of the hinge mechanism in FIG. 12 at a first support arm and a second support arm.

### Reference numerals:

1: hinge mechanism; 101: main shaft module; 1011: base; 10111: bearing surface; 10112: first arc-shaped groove; 10113: body;
10114: cover plate; 101141: first arc-shaped protrusion; 101142: second arc-shaped protrusion; 10115: second arc-shaped groove;
1012: first rotating assembly; 10121: first swing arm; 101211: first arc-shaped rotating block; 101212: first plate surface;
10122: first support arm; 10123: first housing fastening bracket; 101231: first sliding groove; 101232: second sliding groove;
101233: first surface; 101234: second surface;
1013: second rotating assembly; 10131: second swing arm; 101311: second arc-shaped rotating block; 101312: second plate surface;
10132: second support arm; 10133: second housing fastening bracket; 101331: third surface; 101332: fourth surface;
101333: third sliding groove; 101334: fourth sliding groove;
10141: first gear; 101411: first cam structure; 10142: second gear; 101421: second cam structure;
10143: third gear; 101431: fifth cam structure; 10144: fourth gear; 101441: sixth cam structure;
10145: driven gear;
1015: damping assembly; 10151: elastic assembly; 10152: first conjoined cam; 101521: third cam structure;
101522: fourth cam structure; 10153: second conjoined cam;
2: first housing; 2a: first appearance surface; 2b: first support surface;
3: second housing; 3a: second appearance surface; 3b: second support surface;
4: flexible display; 5: screen accommodation space.

### DESCRIPTION OF EMBODIMENTS

To make objectives, technical solutions, and advantages of this application clearer, the following further describes this application in detail with reference to accompanying drawings. Terms used in the following embodiments are merely intended to describe specific embodiments, but are not intended to limit this application. The terms "one", "a", "the", "the foregoing", "this", and "the one" of singular forms used in this specification and the appended claims of this application are also intended to include forms such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

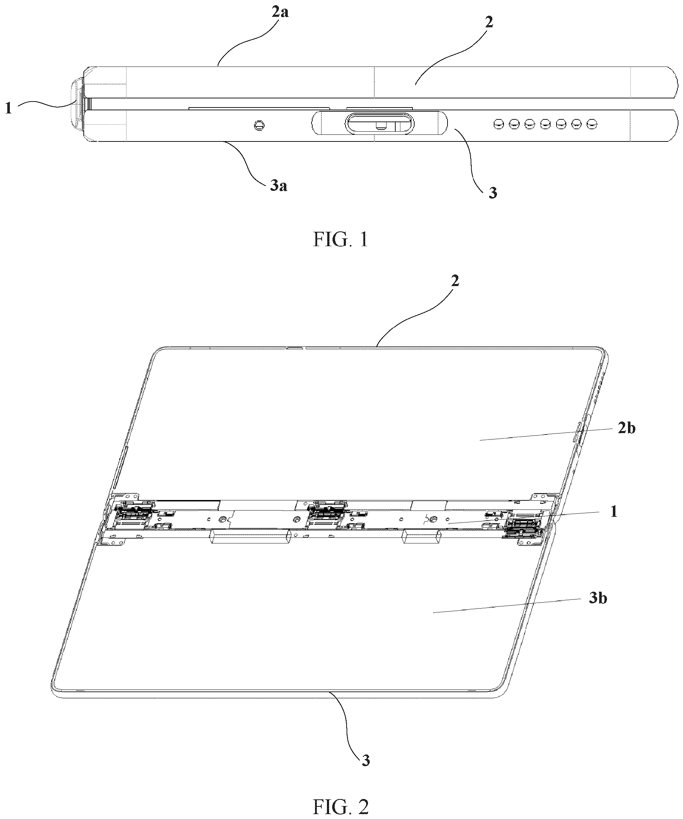

For ease of understanding a hinge mechanism provided in embodiments of this application, the following first describes an application scenario of the hinge mechanism. The hinge mechanism may be but is not limited to being used in a foldable electronic device such as a mobile phone, a palmtop computer (personal digital assistant, PDA), a notebook computer, or a tablet computer. When the hinge mechanism provided in embodiments of this application is used in an electronic device, refer to FIG. 1. FIG. 1 is a diagram of a structure of an electronic device according to an embodiment of this application. In addition to a hinge mechanism 1, the electronic device may further include two housings and a flexible display. In the embodiment shown in FIG. 1, the flexible display is omitted. For ease of description, the two housings may be respectively named a first housing 2 and a second housing 3. The first housing 2 and the second housing 3 are located on two sides of the hinge mechanism 1, and can rotate around the hinge mechanism 1. When the electronic device is used, the electronic device may be folded and unfolded in different use scenarios. The electronic device provided in this application may be an inward-foldable electronic device. In the embodiment shown in FIG. 1, the electronic device is in a folded state, and FIG. 1 shows a relative position relationship between the hinge mechanism 1 and the two housings when the electronic device is in the folded state. In this case, a surface of the hinge mechanism 1, a first appearance surface 2a of the first housing 2, and a second appearance surface 3a of the second housing 3 may be jointly used as an appearance surface of the electronic device. The first appearance surface 2a of the first housing 2 is a surface that is of the first housing 2 and that is away from a flexible display 4, and the second appearance surface 3a of the second housing 3 is a surface that is of the second housing 3 and that is away from the flexible display 4.

In addition, refer to FIG. 2. FIG. 2 is a diagram of a structure of the electronic device in an unfolded state. It should be noted that FIG. 2 shows a structure on a side of a first support surface 2b of the first housing 2 and a second support surface 3b of the second housing 3. The first support surface 2b of the first housing 2 is a surface that is of the first housing 2 and that is configured to support the flexible display, and the second support surface 3b of the second housing 3 is a surface that is of the second housing 3 and that is configured to support the flexible display. The flexible display may continuously cover the first support surface 2b of the first housing 2, the second support surface 3b of the second housing 3, and the hinge mechanism 1, and the flexible display may be fastened to the first support surface 2b of the first housing 2 and the second support surface 3b of the second housing 3. A connection manner thereof may be but is not limited to bonding. In this way, when the electronic device is in the unfolded state shown in FIG. 2, the first housing 2 and the second housing 3 may support the flexible display 4.

In a process in which the first housing 2 and the second housing 3 rotate relatively from the unfolded state shown in FIG. 2 to the folded state shown in FIG. 1, or from the folded state shown in FIG. 1 to the unfolded state shown in FIG. 2, the flexible display may be folded or unfolded with the first housing 2 and the second housing 3.

It may be understood that a process of the electronic device from the unfolded state shown in FIG. 2 to the folded state shown in FIG. 1, or from the folded state shown in FIG. 1 to the unfolded state shown in FIG. 2 is a process in which the first housing 2 and the second housing 3 rotate around the hinge mechanism 1. As a key functional component in a foldable electronic device, the hinge mechanism 1 may be disposed corresponding to a foldable portion of the flexible display. Therefore, the hinge mechanism 1 is important in both supporting the foldable portion of the flexible display 4 in the unfolded state shown in FIG. 2 and accommodating the foldable portion of the flexible display in the folded state shown in FIG. 1.

For example, when the electronic device is in the folded state shown in FIG. 1, if a space formed at the hinge mechanism 1 cannot meet a folding requirement of the flexible display, squeezing or stretching of the flexible display may be caused. As a result, after a folding operation is performed on the electronic device a plurality of times, it is likely to cause damage to the flexible display.

To form a screen accommodation space that meets a requirement for accommodating the foldable portion of the flexible display, currently, some existing hinge mechanisms usually include two movable door plates during specific arrangement. When the electronic device is in the folded state, a water drop-like screen accommodation space may be formed between the two door plates of the hinge mechanism. When the electronic device is in the unfolded state, a base of the hinge mechanism and the two movable door plates may jointly support the foldable portion of the flexible display. However, because the hinge mechanism has a large quantity of support members for supporting the foldable portion of the flexible display, a structure of the hinge mechanism is complex, and processing costs are high. In addition, in the unfolded state, there are a large quantity of step differences between support surfaces that are of the plurality of support members and that are configured to support the flexible display. This affects flatness of an entire support surface that is formed by the plurality of support members and that is configured to support the flexible display, and therefore affects screen light and shadow effect of the flexible display.

The hinge mechanism provided in this application is intended to resolve the foregoing problem, so that when the electronic device is in the folded state, the hinge mechanism can form the screen accommodation space for accommodating the foldable portion of the flexible display, and when the electronic device is in the unfolded state, the hinge mechanism can provide stable support for the flexible display, to improve screen light and shadow effect of the flexible display. To facilitate understanding of the hinge mechanism provided in embodiments of this application, the following describes a specific structure of the hinge mechanism in detail with reference to the accompanying drawings.

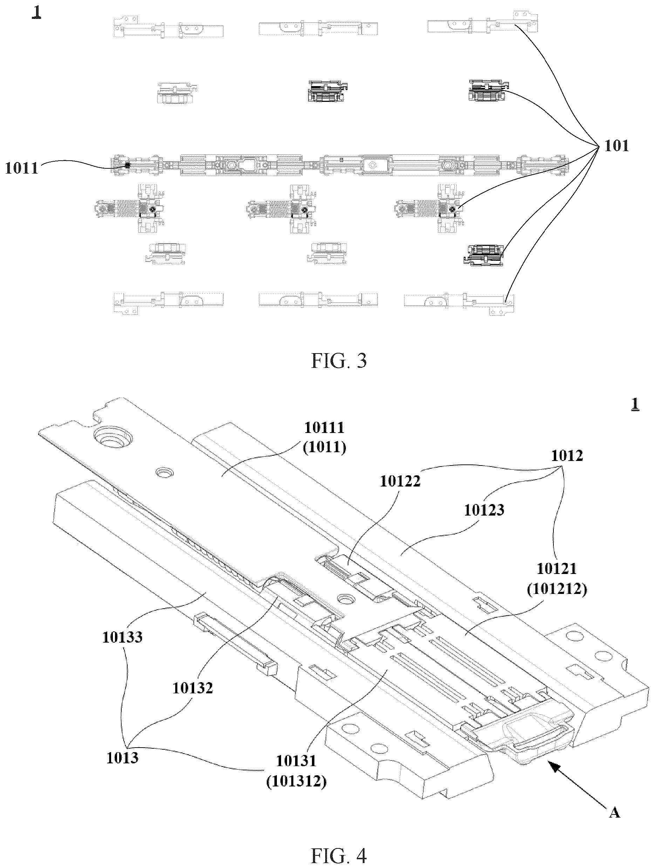

Refer to FIG. 3. FIG. 3 is a schematic exploded view of a structure of the hinge mechanism 1 of the electronic device in FIG. 2. In this application, the hinge mechanism 1 may include a base 1011 and a main shaft module 101. The hinge mechanism 1 may include one main shaft module 101, or may include a plurality of main shaft modules 101. In an embodiment shown in FIG. 3, the hinge mechanism 1 includes three main shaft modules 101, and the three main shaft modules 101 may be arranged at intervals in a length direction of the hinge mechanism 1. In this application, the length direction of the hinge mechanism 1 is an extension direction of an axis of rotation when the first housing 2 and the second housing 3 rotate around the hinge mechanism 1 shown in FIG. 1 or FIG. 2. The first housing 2 and the second housing 3 may be rotatably connected through the plurality of main shaft modules 101. This can effectively improve rotation stability of the first housing 2 and the second housing 3 of the electronic device relative to the hinge mechanism 1.

During specific arrangement of the main shaft module 101, refer to FIG. 4. FIG. 4 is a diagram of a partial structure of the hinge mechanism 1 according to a possible embodiment of this application. Refer to FIG. 3 and FIG. 4 together. In this application, the main shaft module 101 may include a base 1011, a first rotating assembly 1012, and a second rotating assembly 1013. The base 1011 may be used as a bearing component for the first rotating assembly 1012 and the second rotating assembly 1013. The first rotating assembly 1012 and the second rotating assembly 1013 are respectively disposed on two sides of the base 1011, and the first rotating assembly 1012 and the second rotating assembly 1013 may be symmetrically disposed relative to the base 1011. For ease of description, in the following embodiments of this application, the main shaft module 101 is mainly described by using a specific arrangement manner of the first rotating assembly 1012 and a connection relationship between the first rotating assembly 1012 and the base 1011 as an example, and the second rotating assembly 1013 may be disposed with reference to the first rotating assembly 1012.

It should be noted that, in a possible embodiment of this application, when there are a plurality of main shaft modules 101, reference may be made to FIG. 3 and FIG. 4 together. A same base 1011 may be used as a bearing component for all of first rotating assemblies 1012 and second rotating assemblies 1013 of the plurality of main shaft modules 101, to improve an integration degree of the hinge mechanism 1. In some other possible embodiments of this application, one base 1011 may be disposed, corresponding to each main shaft module 101, on the hinge mechanism 1, so that a corresponding base 1011 is used as a bearing component for a first rotating assembly 1012 and a second rotating assembly 1013 of each main shaft module 101.

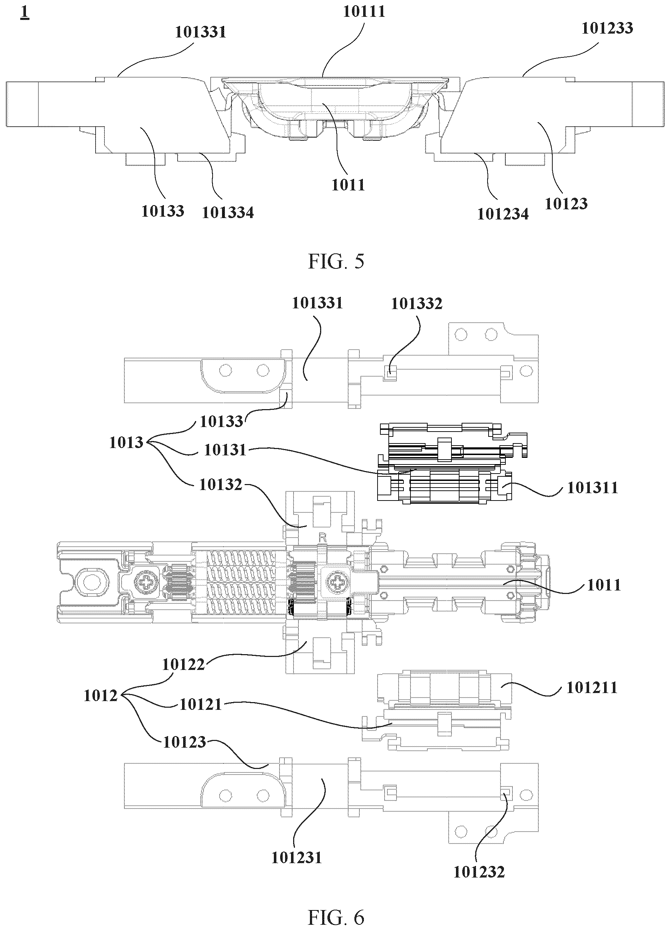

Still refer to FIG. 4. In this application, the base 1011 may include a bearing surface 10111. When the hinge mechanism 1 is used in the electronic device shown in FIG. 1 or FIG. 2, the bearing surface 10111 may be disposed toward the flexible display. In addition, refer to FIG. 5. FIG. 5 is an A-direction view of the hinge mechanism 1 shown in FIG. 4, and shows a structure of the hinge mechanism 1 of the electronic device in the unfolded state. In this state, the foldable portion of the flexible display may be supported by the bearing surface 10111 of the base 1011. This can effectively simplify the structure of the hinge mechanism 1, and can reduce step difference positions of the support members for supporting the flexible display. In addition, because flatness of the bearing surface 10111 of the base 1011 is easy to control, flatness of the foldable portion of the flexible display can be greatly improved, thereby effectively improving light and shadow effect of the flexible display and improving user experience.

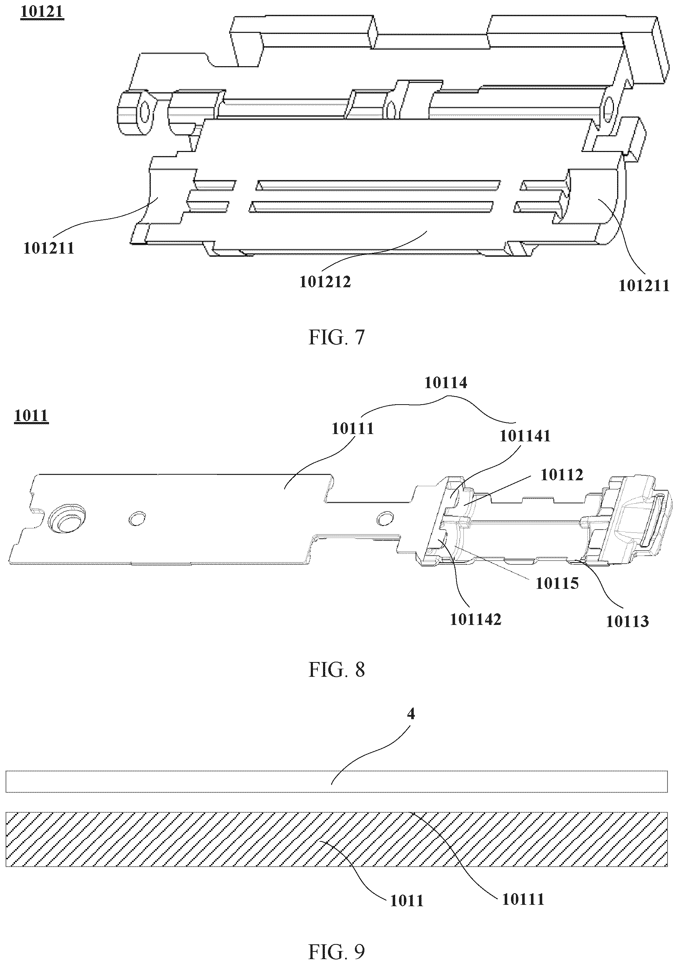

Refer to FIG. 6. FIG. 6 is a schematic exploded view of a structure of the hinge mechanism 1 shown in FIG. 4. In this application, the first rotating assembly 1012 may include a first swing arm 10121, and the first swing arm 10121 is rotatably connected to the base 1011. In a possible embodiment of this application, the first swing arm 10121 may be rotatably connected to the base 1011 through a virtual shaft. The virtual shaft is an axis center of a circular-arc-shaped structure. Two components that are rotatably connected may rotate relative to the virtual shaft, and a position of the virtual shaft is fixed as the two components that are rotatably connected rotate relative to each other. For example, refer to FIG. 7. FIG. 7 is a diagram of a structure of the first swing arm 10121 according to a possible embodiment of this application. A first arc-shaped rotating block 101211 may be disposed at an end that is of the first swing arm 10121 and that is configured to be connected to the base 1011. In addition, refer to FIG. 8. FIG. 8 is a diagram of a partial structure of the base 1011. A first arc-shaped groove 10112 may be provided on the base 1011. The first arc-shaped rotating block 101211 of the first swing arm 10121 shown in FIG. 7 may be accommodated in the first arc-shaped groove 10112 and is capable of sliding along an arc-shaped surface of the first arc-shaped groove 10112, so that the first swing arm 10121 rotates around the base 1011. The first swing arm 10121 is rotatably connected to the base 1011 through the virtual shaft. This can help reduce a space occupied by the first swing arm 10121 on the base 1011, to help reduce a volume of the main shaft module 101, and implement a miniaturization design of the hinge mechanism 1. It should be noted that, in this application, the first arc-shaped rotating block 101211 may be but is not limited to a circular-arc-shaped rotating block, and the first arc-shaped groove 10112 may be but is not limited to a circular-arc-shaped groove.

Still refer to FIG. 8. The base 1011 may include a body 10113 and a cover plate 10114. The cover plate 10114 may cover the body 10113. In this case, when the hinge mechanism 1 is used in the electronic device shown in FIG. 1 or FIG. 2, the bearing surface 10111 of the base 1011 is a surface that is of the cover plate 10114 and that is disposed toward the flexible display. The cover plate 10114 and the body 10113 may be fastened, and a fastening manner may be but is not limited to a welding or threaded connection, to form an accommodation space between the cover plate 10114 and the body 10113. It should be noted that, in this application, one cover plate 10114 may be separately disposed for each main shaft module 101, so that a structure of the main shaft module 101 is flexible. Alternatively, the plurality of main shaft modules 101 may share one cover plate 10114, to simplify the structure of the hinge mechanism 1.

It can be seen from FIG. 8 that, the first arc-shaped groove 10112 may be provided on the body 10113 of the base 1011. In addition, a first arc-shaped protrusion 101141 may be disposed on a surface that is of the cover plate 10114 and that faces the first arc-shaped groove 10112. In this way, the first arc-shaped rotating block 101211 of the first swing arm 10121 shown in FIG. 7 may be inserted between the first arc-shaped protrusion 101141 and the first arc-shaped groove 10112. In this way, the first arc-shaped protrusion 101141 limits the first arc-shaped rotating block 101211 of the first swing arm 10121 to being located in the first arc-shaped groove 10112 of the base 1011, to reduce a risk that the first swing arm 10121 falls off from the base 1011, thereby improving movement reliability of the first swing arm 10121.

In another possible embodiment of this application, the base 1011 may alternatively be of an integrated structure. In this case, the first arc-shaped groove 10112 may be of an integrated channel structure directly provided on the base 1011. This can implement an integrated design of the base 1011, and improve structural reliability of the hinge mechanism 1. In addition, corresponding to each first swing arm 10121, a quantity of first arc-shaped grooves 10112 of the base 1011 may be but is not limited to at least two, and the at least two first arc-shaped grooves 10112 may be provided at intervals in a length direction of the base 1011. In addition, still refer to FIG. 7 and FIG. 8. A quantity of first arc-shaped rotating blocks 101211 of the first swing arm 10121 may be the same as the quantity of first arc-shaped grooves 10112, so that each first arc-shaped rotating block 101211 may be accommodated in one first arc-shaped groove 10112 in a one-to-one correspondence. In this way, the at least two first arc-shaped grooves 10112 can limit the first arc-shaped rotating block 101211, to improve reliability of a connection between the first arc-shaped rotating block 101211 and the base 1011.

In some other embodiments of this application, the first swing arm 10121 may alternatively be rotatably connected to the base 1011 through a physical shaft. For example, the first swing arm 10121 may be rotatably connected to the base 1011 through one hinge pin. In this way, when the hinge mechanism 1 includes the plurality of main shaft modules 101, a first swing arm 10121 of at least one main shaft module 101 of the plurality of main shaft modules 101 may be rotatably connected to the base 1011 through a virtual shaft, and a first swing arm 10121 of at least one main shaft module 101 may be rotatably connected to the base 1011 through a solid shaft. In this case, a first swing arm 10121 of a main shaft module 101 disposed opposite to the flexible display of the electronic device may be rotatably connected to the base 1011 through a virtual shaft, and first swing arms 10121 of main shaft modules 101 located at two end portions in the length direction of the hinge mechanism 1 may be rotatably connected to the base 1011 through a physical shaft.

Still refer to FIG. 7. In this application, the first swing arm 10121 may further have a first plate surface 101212. When the hinge mechanism 1 is used in the electronic device shown in FIG. 1 or FIG. 2, the first plate surface 101212 may be disposed toward the flexible display. As shown in FIG. 7, when the first swing arm 10121 has two first arc-shaped rotating blocks 101211, in the length direction of the base, the two first arc-shaped rotating blocks 101211 may be respectively disposed on two sides of the first plate surface 101212. In addition, refer to FIG. 4. In a possible embodiment of this application, when the electronic device is in the unfolded state, the first plate surface 101212 may be flush with the bearing surface 10111, so that in the unfolded state, the bearing surface 10111 and the first plate surface 101212 can jointly provide flat support for the flexible display.

Still refer to FIG. 4. When the electronic device is in the unfolded state, the first plate surface 101212 may be connected to the bearing surface 10111, to form a complete support surface. In this way, integrity of a structure used by the hinge mechanism to support the foldable portion of the flexible display can be improved, thereby helping improve the flatness of the foldable portion of the flexible display.

Still refer to FIG. 6. In this application, the first rotating assembly 1012 may further include a first support arm 10122, and the first support arm 10122 may be rotatably connected to the base 1011. For example, the first support arm 10122 may be rotatably connected to the base 1011 through a hinge pin. During specific implementation, a damping bracket may be disposed on the base 1011, and a first shaft may penetrate both the damping bracket and the first support arm 10122, so that the first support arm 10122 is rotatably connected to the damping bracket through the first shaft, to implement a rotatable connection between the first support arm 10122 and the base 1011.

It should be noted that, in this application, the first support arm 10122 may be rotatably connected to the damping bracket through a hinge pin. In some possible embodiments, the first support arm 10122 may alternatively be rotatably connected to the damping bracket through a virtual shaft. For example, an arc-shaped groove may be provided on the damping bracket, and an arc-shaped rotating block is disposed on the first support arm 10122, so that the first support arm 10122 rotates with the damping bracket through sliding of the arc-shaped rotating block along a groove surface of the arc-shaped groove.

Still refer to FIG. 6. In this application, the first rotating assembly 1012 may further include a first housing fastening bracket 10123. When the hinge mechanism 1 is used in the electronic device shown in FIG. 1 or FIG. 2, the first housing fastening bracket 10123 may be fastened to the first housing 2. The first housing fastening bracket 10123 may be connected to the first support arm 10122 and the first swing arm 10121. During specific arrangement of the first housing fastening bracket 10123, a first sliding groove 101231 may be provided on the first housing fastening bracket 10123, and the first sliding groove 101231 extends in a first direction. The first support arm 10122 may be mounted in the first sliding groove 101231 and is capable of sliding in the first sliding groove 101231. The first direction may be a direction in which the first housing fastening bracket 10123 moves toward or away from the base 1011. In addition, to prevent the first support arm 10122 from falling off from the first sliding groove 101231, a first sliding rail may be disposed on a groove wall of the first sliding groove 101231, and a first sliding block may be disposed on the first support arm 10122. In this way, the first sliding block may be clamped on the first sliding rail, and the first sliding block can slide along the first sliding rail, to limit the first support arm 10122 to being located in the first sliding groove 101231. In addition, the first sliding rail is disposed on the groove wall of the first sliding groove 101231, which may provide guidance for sliding of the first support arm 10122 along the first sliding groove 101231. This improves movement stability of the first support arm 10122.

Still refer to FIG. 6. A second sliding groove 101232 may be further provided on the first housing fastening bracket 10123. The second sliding groove 101232 may extend in a second direction, and in a length direction of the first housing fastening bracket 10123, the first sliding groove 101231 and the second sliding groove 101232 are provided at intervals. Refer to FIG. 6 and FIG. 7 together. An end portion that is of the first swing arm 10121 and that faces the first housing fastening bracket 10123 may be mounted in the second sliding groove 101232, and the first swing arm 10121 is capable of sliding in the second sliding groove 101232. In this application, refer to FIG. 5. The first housing fastening bracket 10123 may include a first surface 101233 and a second surface 101234 that are disposed back to each other. When the hinge mechanism 1 is used in the electronic device shown in FIG. 1 or FIG. 2, the first surface 101233 may be a surface on a side that is of the first housing fastening bracket 10123 and that faces the flexible display 4. In this way, the second direction may be a direction from the first surface 101233 to the second surface 101234, or from the second surface 101234 to the first surface 101233. In addition, a projection of the second direction onto a first cross section may be not parallel to a projection of the first direction onto the first cross section. The first cross section may be a reference plane perpendicular to a rotation axis of the first support arm 10122 and a rotation axis of the first swing arm 10121.

In addition, still refer to FIG. 6. In this application, a second sliding rail may be disposed in the second sliding groove 101232, and a second sliding block may be disposed on the first swing arm 10121 shown in FIG. 7. In this way, the second sliding block may be clamped on the second sliding rail, and the second sliding block may slide in the second sliding rail in the second direction, to limit the first swing arm 10121 to being located in the second sliding groove 101232, thereby preventing the first swing arm 10121 from falling off from the second sliding groove 101232. In addition, the second sliding rail is disposed on a groove wall of the second sliding groove 101232, which may provide guidance for sliding of the first swing arm 10121 along the second sliding groove 101232. This improves movement stability of the first swing arm 10121.

It can be learned from the foregoing description that, in this application, the second rotating assembly 1013 and the first rotating assembly 1012 may be symmetrically disposed relative to the base 1011. During specific implementation, refer to FIG. 5 and FIG. 6. The second rotating assembly 1013 may include a second swing arm 10131, and the second swing arm 10131 may be disposed with reference to the first swing arm 10121 shown in FIG. 7. To implement a rotatable connection between the second swing arm 10131 and the base 1011, a second arc-shaped rotating block 101311 may be disposed on the second swing arm 10131. Refer to FIG. 8. The base 1011 may include a second arc-shaped groove 10115. In addition, a second arc-shaped protrusion 101142 may be disposed on a surface that is of the cover plate 10114 and that faces the second arc-shaped groove 10115. The second arc-shaped groove 10115 may be provided with reference to the first arc-shaped groove 10112, the second arc-shaped rotating block 101311 may be disposed with reference to the first arc-shaped rotating block 101211, and the second arc-shaped protrusion 101142 may be disposed with reference to the first arc-shaped protrusion 101141. Details are not described herein again.

Refer to FIG. 4. In this application, the second swing arm 10131 may further have a second plate surface 101312. When the hinge mechanism 1 is used in the electronic device shown in FIG. 1 or FIG. 2, the second plate surface 101312 may be disposed toward the flexible display. When the second swing arm 10131 has two second arc-shaped rotating blocks 101311, in the length direction of the base, the two second arc-shaped rotating blocks 101311 may be respectively disposed on two sides of the second plate surface 101312. In addition, when the electronic device is in the unfolded state, the second plate surface 101312 may be flush with the bearing surface 10111, so that in the unfolded state, the bearing surface 10111 and the second plate surface 101312 can jointly provide flat support for the flexible display.

Still refer to FIG. 4. When the electronic device is in the unfolded state, the first plate surface 101212 and the second plate surface 101312 may be connected to the bearing surface 10111, to form a complete support surface. In this way, integrity of a structure used by the hinge mechanism to support the foldable portion of the flexible display can be improved, thereby helping improve the flatness of the foldable portion of the flexible display.

The second rotating assembly 1013 may further include a second support arm 10132, and the second support arm 10132 is rotatably connected to the base 1011. When the second support arm 10132 is connected to the base 1011, the second support arm 10132 may be disposed with reference to a connection manner between the first support arm 10122 and the base 1011. Details are not described herein again.

In addition, the second rotating assembly 1013 may further include a second housing fastening bracket 10133. When the hinge mechanism 1 is used in the electronic device, the second housing fastening bracket 10133 may be fastened to the second housing 3. The second housing fastening bracket 10133 has a third surface 101331 and a fourth surface 101332 that are disposed back to each other. When the hinge mechanism 1 is used in the electronic device, the third surface 101331 is a surface on a side that is of the second housing fastening bracket 10133 and that faces the flexible display 4. In addition, the second housing fastening bracket 10133 may include a third sliding groove 101333 extending in a third direction and a fourth sliding groove 101334 extending in a fourth direction. The second support arm 10132 is capable of sliding in the third sliding groove 101333, and the second swing arm 10131 is capable of sliding in the fourth sliding groove 101334. A projection of the third direction onto a second cross section is not parallel to a projection of the fourth direction onto the second cross section. The second cross section is a reference plane perpendicular to a rotation axis of the second support arm 10132 and a rotation axis of the second swing arm 10131.

In addition, still refer to FIG. 6. A third sliding rail may be disposed in the third sliding groove 101333, a third sliding block may be disposed on the second support arm 10132, a fourth sliding rail may be disposed in the fourth sliding groove 101334, and a fourth sliding block may be disposed on the second swing arm 10131. For an arrangement manner of the third sliding rail, refer to the first sliding rail. For an arrangement manner of the third sliding block, refer to the first sliding block. For an arrangement manner of the fourth sliding rail, refer to the second sliding rail. For an arrangement manner of the fourth sliding block, refer to the second sliding block. Details are not described herein again.

After a connection relationship between the first rotating assembly 1012 and the second rotating assembly 1013 and the base 1011 provided in the foregoing embodiments of this application is understood, the following describes movement of the hinge mechanism 1. First, refer to FIG. 4 and FIG. 5. FIG. 4 and FIG. 5 are diagrams of the structure of the hinge mechanism 1 of the electronic device in the unfolded state. In this case, a distance between the base 1011 and edges that are of the first housing fastening bracket 10123 and the second housing fastening bracket 10133 and that face the base 1011 is shortest, and the bearing surface 10111 of the base 1011 can provide stable support for the foldable portion of the flexible display 4. Refer to FIG. 9. FIG. 9 is a diagram of a structure in which the bearing surface 10111 of the base 1011 supports the foldable portion of the flexible display 4 in the unfolded state.

In addition, in the unfolded state, positions in which step differences may exist in the hinge mechanism 1 are only between the first housing fastening bracket 10123 and the base 1011, between the second housing fastening bracket 10133 and the base 1011, between the first housing fastening bracket 10123 and the first swing arm 10121, and between the second housing fastening bracket 10133 and the second swing arm 10131. Specifications of components related to these positions are easy to control, and may be adjusted for a limited number of times, so that in the unfolded state, the first surface 101233 of the first housing fastening bracket 10123, the third surface 101331 of the second housing fastening bracket 10133, the first plate surface 101212 of the first swing arm 10121, and the second plate surface 101312 of the second swing arm 10131 are flush with the bearing surface 10111 of the base 1011. It can also be learned from the foregoing description that the first housing fastening bracket 10123 may be fastened to the first housing 2, and the second housing fastening bracket 10133 may be fastened to the second housing 3. In this way, specifications of the housing fastening bracket and the housing that are fastened are controlled, so that the first surface 101233 of the first housing fastening bracket 10123 may be flush with the first support surface 2b of the first housing 2, and the third surface 101331 of the second housing fastening bracket 10133 is also flush with the second support surface 3b of the second housing 3. In this way, flat support can be provided for the flexible display 4, to effectively improve screen light and shadow effect of the flexible display 4.

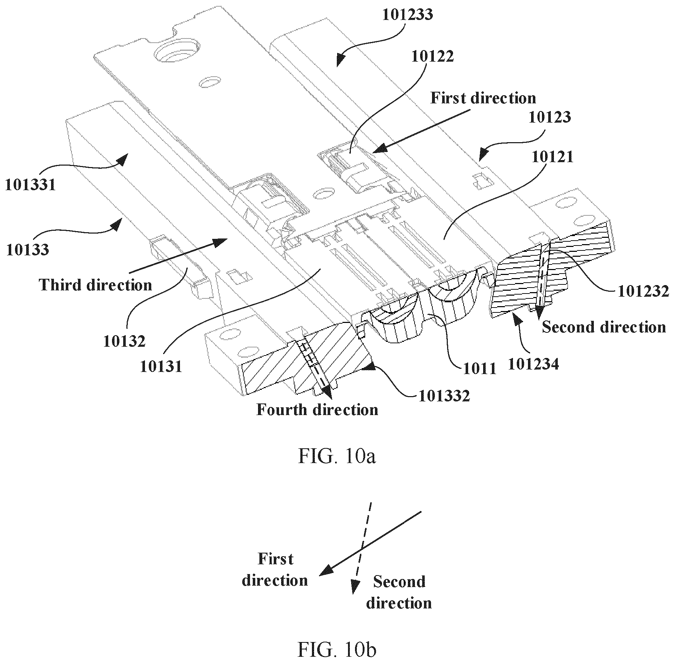

It can be learned from the description of the foregoing embodiments that, when the hinge mechanism 1 rotates from the unfolded state to the folded state, the first support arm 10122 may slide in the first sliding groove 101231 in the first direction, and the first swing arm 10121 may slide in the second sliding groove 101232 in the second direction. Similarly, the second support arm 10132 may slide in the third sliding groove 101333 in the third direction, and the second swing arm 10131 may slide in the fourth sliding groove 101334 in the fourth direction. Refer to FIG. 10a. FIG. 10a is a diagram of a partial structure of the hinge mechanism shown in FIG. 4. In FIG. 10a, solid lines with arrows respectively indicate the first direction and the third direction, and dashed lines with arrows respectively indicate the second direction and the fourth direction. In addition, refer to FIG. 10b. FIG. 10b is a diagram of the first cross section according to a possible embodiment. In the first cross section, the first direction and the second direction intersect, and an angle at which the first direction and the second direction intersect may be an acute angle in the figure, or may be another possible angle, for example, a right angle or an obtuse angle. In addition, in the second cross section, a position relationship between the third direction and the fourth direction may be symmetrical with a position relationship between the first direction and the second direction shown in FIG. 10b. Details are not described herein again.

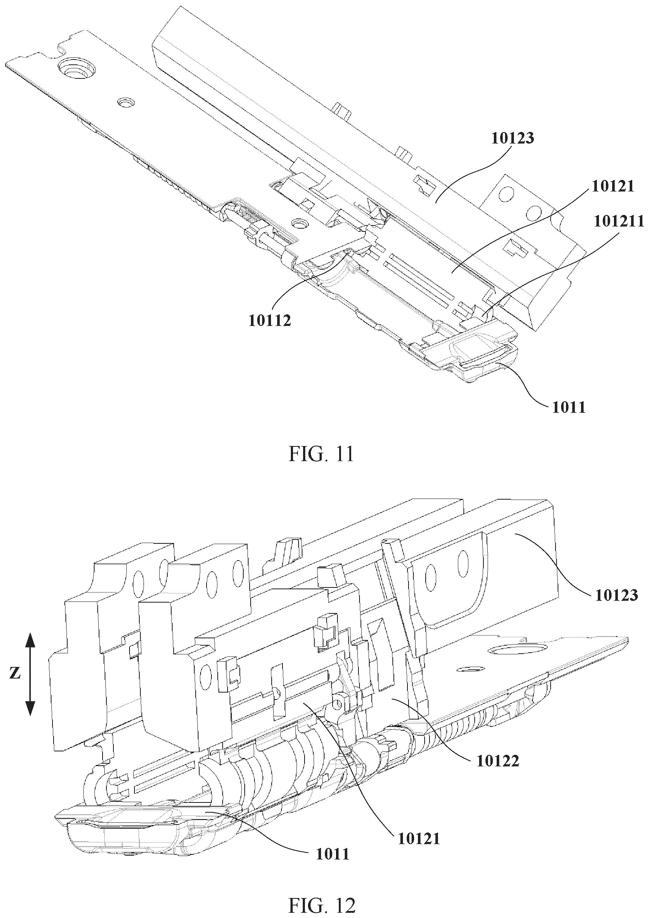

Refer to FIG. 11. FIG. 11 is a diagram of a structure of the hinge mechanism 1 of the electronic device in an intermediate state. It can be learned from a comparison between FIG. 4 and FIG. 11 that, in this process, the first housing fastening bracket 10123 may move in a direction away from the base 1011 relative to the first support arm 10122, and drive the first support arm 10122 and the first swing arm 10121 to rotate around the base 1011. The first arc-shaped rotating block 101211 of the first swing arm 10121 moves in a direction of sliding out of the corresponding first arc-shaped groove 10112, so that a part that is of the first arc-shaped rotating block 101211 and that is accommodated in the corresponding first arc-shaped groove 10112 is reduced. Similarly, the second housing fastening bracket 10133 may drive the second support arm 10132 and the second swing arm 10131 to rotate around the base 1011. A specific movement process of the second housing fastening bracket 10133 is similar to a movement process in which the first housing fastening bracket 10123 drives the first support arm 10122 and the first swing arm 10121 to rotate around the base 1011. Details are not described herein again.

Refer to FIG. 12. FIG. 12 is a diagram of a structure of the hinge mechanism 1 of the electronic device in the folded state. In a process from FIG. 11 to FIG. 12, the first housing fastening bracket 10123 continues to move in the direction away from the base 1011 relative to the first support arm 10122, and drives the first support arm 10122 to rotate around the base 1011. The first arc-shaped rotating block 101211 of the first swing arm 10121 continues to move in the direction of sliding out of the corresponding first arc-shaped groove 10112, so that the part that is of the first arc-shaped rotating block 101211 and that is accommodated in the corresponding first arc-shaped groove 10112 is further reduced. Similarly, the second housing fastening bracket 10133 may drive the second support arm 10132 and the second swing arm 10131 to continue to rotate around the base 1011. A specific movement process of the second housing fastening bracket 10133 is similar to a movement process in which the first housing fastening bracket 10123 drives the first support arm 10122 and the first swing arm 10121 to rotate around the base 1011. Details are not described herein again.

It may be understood that, when the electronic device rotates from the folded state shown in FIG. 12 to the unfolded state shown in FIG. 4, the first housing fastening bracket 10123, the first support arm 10122, the first swing arm 10121, the second housing fastening bracket 10133, the second support arm 10132, and the second swing arm 10131 may separately move in a direction opposite to a direction in rotation processes shown in FIG. 4 to FIG. 9, FIG. 10a, FIG. 10b, to FIG. 11 and FIG. 12. Details are not described herein.

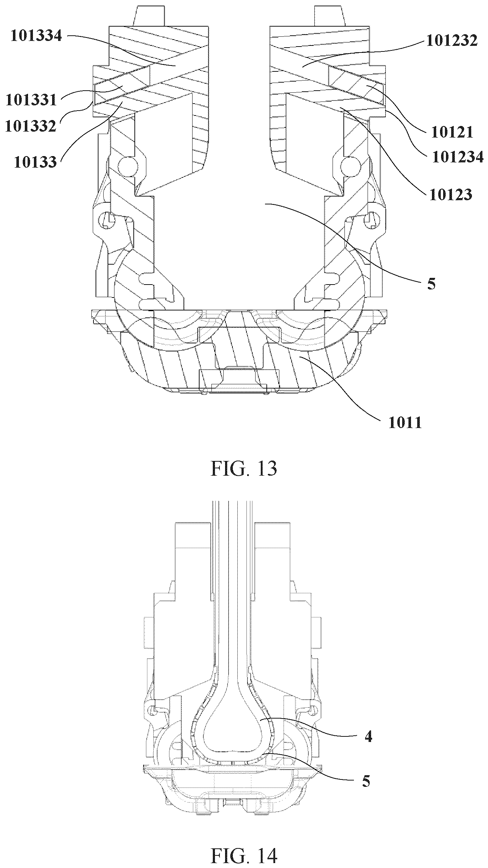

Refer to FIG. 13. FIG. 13 is a cross-sectional view of the hinge mechanism 1 in FIG. 12 at the first swing arm 10121 and the second swing arm 10131. It can be seen from the figure that, in the folded state, one screen accommodation space 5 may be formed between the first housing fastening bracket 10123, the second housing fastening bracket 10133, and the base 1011. Refer to FIG. 14. FIG. 14 is a diagram of a partial structure of the hinge mechanism of the electronic device. It can be seen from FIG. 14 that the foldable portion of the flexible display 4 may be accommodated in the screen accommodation space 5.

In addition, in the folded state, the first support arm 10122 and the first swing arm 10121 both have a support force for the first housing fastening bracket 10123 in a Z direction shown in FIG. 12. This can effectively improve a movement bonding degree between the first support arm 10122 and the first swing arm 10121 and the first housing fastening bracket 10123, and can stop the first housing fastening bracket 10123 in the direction. Similarly, the second support arm 10132 and the second swing arm 10131 may also both have a support force for the second housing fastening bracket 10133 in the Z direction. This can effectively improve a movement bonding degree between the second support arm 10132 and the second swing arm 10131 and the second housing fastening bracket 10133, and can stop the second housing fastening bracket 10133 in the direction. In this way, even if the electronic device in which the hinge mechanism 1 is used falls in the folded state, a risk that the first housing fastening bracket 10123 and the second housing fastening bracket 10133 have large instantaneous displacement in this state can be effectively reduced, thereby ensuring reliability of an overall structure of the electronic device.

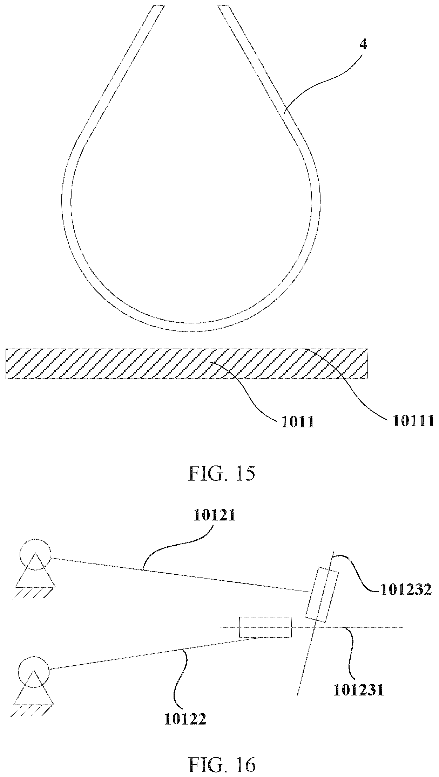

Refer to FIG. 15. FIG. 15 is a diagram of a structure in which the bearing surface 10111 of the base 1011 supports the foldable portion of the flexible display 4 in the folded state. Refer to FIG. 14 and FIG. 15 together. In the folded state, reliability of a structure for forming the screen accommodation space 5 in the hinge mechanism 1 is better. Therefore, when the electronic device falls in the folded state, squeezing of the foldable portion of the flexible display 4 can be avoided. This can help improve structural reliability of the flexible display 4 and prolong a service life of the flexible display 4.

Refer to FIG. 10a. When the electronic device is in the unfolded state, a distance between the second sliding block of the first swing arm 10121 and the first surface 101233 of the first housing fastening bracket 10123 is shortest. In addition, refer to FIG. 13. When the electronic device is in the folded state, a distance between the second sliding block of the first swing arm 10121 and the second surface 101234 of the first housing fastening bracket 10123 is shortest. It can be learned that, in a process in which the electronic device changes from the unfolded state to the folded state, the second sliding block of the first swing arm 10121 may slide in the second sliding groove 101232 in a direction from the first surface 101233 to the second surface 101234. Because the second swing arm 10131 and the first swing arm 10121 are symmetrically disposed, in the process from the unfolded state to the folded state, the fourth sliding block of the second swing arm 10131 may slide in the fourth sliding groove 101334 in a direction from the third surface 101331 to the fourth surface 101332.

It can be learned from the foregoing descriptions of the first sliding groove 101231 and the second sliding groove 101232 of the first housing fastening bracket 10123, and the third sliding groove 101333 and the fourth sliding groove 101334 of the second housing fastening bracket 10133 that, a sliding direction of the first support arm 10122 in the first sliding groove 101231 intersects a sliding direction of the first swing arm 10121 in the second sliding groove 101232, and a sliding direction of the second support arm 10132 in the third sliding groove 101333 intersects a sliding direction of the second swing arm 10131 in the fourth sliding groove 101334. Based on this, refer to FIG. 16. FIG. 16 is a diagram of a principle of a mechanism in which the first support arm 10122 and the first swing arm 10121 slide relative to the first housing fastening bracket 10123 according to an embodiment of this application. It can be seen from FIG. 16 that, by using the hinge mechanism 1 provided in this application, when the first support arm 10122 and the first swing arm 10121 rotate around the base 1011, rotation axis centers of the first support arm 10122 and the first swing arm 10121 do not coincide with each other. In this way, an axis center phase difference between the first support arm 10122 and the first swing arm 10121 can be implemented. In addition, opening directions of the first sliding groove 101231 and the second sliding groove 101232 of the first housing fastening bracket 10123 are appropriately designed, so that rotation angles of the first support arm 10122 and the first swing arm 10121 relative to the base 1011 can be neither greater than 90°. In comparison with an existing solution, the rotation angle of the first swing arm 10121 can be effectively reduced. In this way, a wall thickness design of a partial structure of the first swing arm 10121 can meet a strength requirement, so that structural reliability of the first swing arm 10121 is improved. It may be understood that FIG. 16 may also indicate a principle of a mechanism in which the second support arm 10132 and the second swing arm 10131 slide relative to the second housing fastening bracket 10133. It can be learned from the foregoing analysis that, in this application, opening directions of the third sliding groove 101333 and the fourth sliding groove 101334 are appropriately designed, so that rotation angles of the second support arm 10132 and the second swing arm 10131 relative to the base 1011 can be neither greater than 90°, thereby reducing the rotation angle of the second swing arm 10131. In this way, a wall thickness design of a partial structure of the second swing arm 10131 meets a strength requirement, so that structural reliability of the second swing arm 10131 is improved. In addition, when the hinge mechanism 1 is used in the electronic device, a case in which a component in the electronic device is thinned to avoid rotation of the first swing arm 10121 and the second swing arm 10131 can be effectively avoided. This can improve reliability of the overall structure of the electronic device.

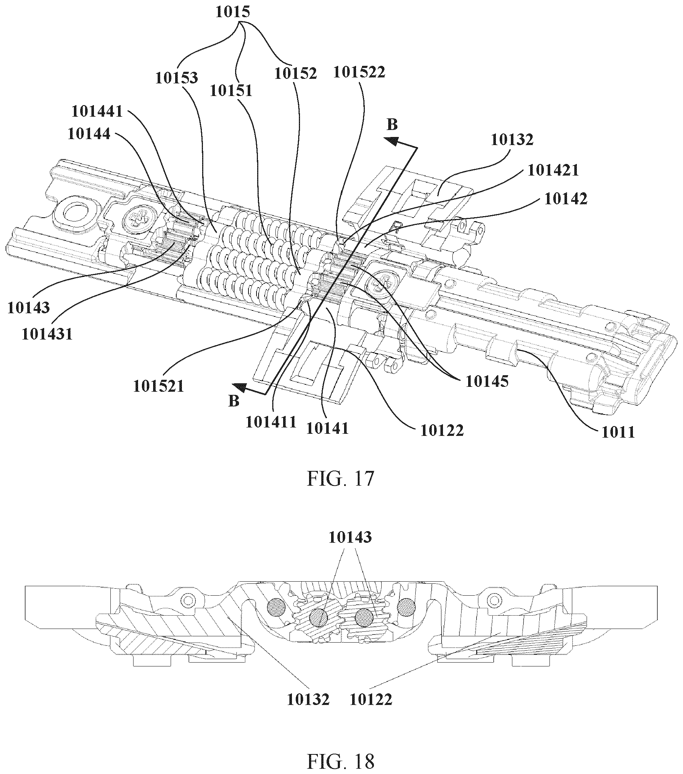

In addition to the foregoing structures, in some embodiments of this application, another possible structure may be further disposed in the hinge mechanism 1. For example, refer to FIG. 17. FIG. 17 is a diagram of a structure of the hinge mechanism 1 according to an embodiment of this application. In the hinge mechanism 1 shown in FIG. 17, the first swing arm 10121, the second swing arm 10131, the first housing fastening bracket 10123, and the second housing fastening bracket 10133 are omitted. In this application, the main shaft module 101 may further include a synchronization assembly. The synchronization assembly may include a first gear 10141 disposed at an end portion of the first support arm 10122 and a second gear 10142 disposed at an end portion of the second support arm 10132. The first gear 10141 and the second gear 10142 are engaged with each other, the first gear 10141 and the first support arm 10122 rotate coaxially, and the second gear 10142 and the second support arm 10132 rotate coaxially. In this way, in a process in which one support arm rotates around the base 1011, the other support arm may be driven to synchronously rotate around the base 1011 toward or away from the support arm, and two support arms rotate at a same angle.

To improve stability of synchronous rotation of the first support arm 10122 and the second support arm 10132, the synchronization assembly may further include a driven gear 10145, and the driven gear 10145 may be disposed between the first gear 10141 and the second gear 10142. In addition, there may be an even number of driven gears 10145, adjacent driven gears 10145 are engaged with each other, an adjacent driven gear 10145 and the first gear 10141 are engaged with each other, and an adjacent driven gear 10145 and the second gear 10142 are engaged with each other, so that the first gear 10141 and the second gear 10142 can synchronously rotate by using the even number of driven gears 10145.

To improve movement stability of the synchronization assembly, in this application, the first gear 10141 and the second gear 10142 may be separately sleeved on a hinge pin on a corresponding side. For example, the first gear 10141 may be sleeved on the first shaft, and the second gear 10142 may be sleeved on the second shaft. In addition, the synchronization assembly may further include an intermediate shaft. The intermediate shaft may be located between the first shaft and the second shaft, and each driven gear 10145 is sleeved on one intermediate shaft.

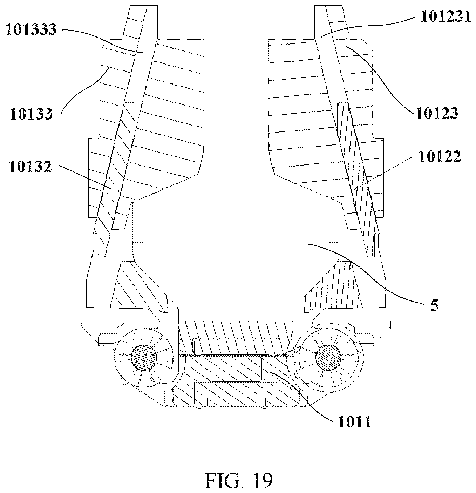

It should be noted that, in this application, the synchronization assembly may be disposed in the accommodation space of the base 1011, so that the structure of the hinge mechanism 1 is compact. Refer to FIG. 18. FIG. 18 is a B-B cross-sectional view of the hinge mechanism 1 shown in FIG. 17. In the hinge mechanism 1 provided in this application, the synchronization assembly is disposed, so that in a process in which one support arm rotates around the base 1011, the other support arm can be driven to synchronously rotate around the base 1011 toward or away from the support arm. In addition, each support arm may slide along a sliding groove of a housing fastening bracket on a corresponding side. Therefore, in a process in which the support arm rotates around the base 1011, the housing fastening bracket on the same side may rotate at a same angle, so that two housing fastening brackets can synchronously rotate in a process in which the two support arms synchronously rotate. For example, in a process in which the electronic device changes from the unfolded state shown in FIG. 18 to the folded state shown in FIG. 19, the first support arm 10122 rotates around the base 1011 to drive the second support arm 10132 to rotate around the base 1011 toward the first support arm 10122, the first support arm 10122 may slide along the first sliding groove 101231 of the first housing fastening bracket 10123, and the second support arm 10132 may slide along the third sliding groove 101333 of the second housing fastening bracket 10133. In this way, the first housing fastening bracket 10123 and the first support arm 10122 may rotate at a same angle, and the second housing fastening bracket 10133 and the second support arm 10132 may rotate at a same angle, so that the two housing fastening brackets synchronously rotate toward each other. It may be understood that, in a process in which the electronic device changes from the folded state shown in FIG. 19 to the unfolded state shown in FIG. 18, the two housing fastening brackets may synchronously rotate away from each other.

In addition, because each housing fastening bracket may be fastened to one housing of the electronic device, synchronous rotation of the two housing fastening brackets may implement synchronous rotation of the two housings of the electronic device. In this way, an instantaneous acting force may be avoided from being applied to the flexible display fastened to the two housings, thereby helping improve reliability of the flexible display.

Still refer to FIG. 17. In this application, a damping assembly 1015 may be further disposed in the main shaft module 101. The damping assembly 1015 may include an elastic assembly 10151 and a first conjoined cam 10152. In a length direction of the main shaft module 101, the first conjoined cam 10152 is located between the elastic assembly 10151 and the first support arm 10122, and the first conjoined cam 10152 is located between the elastic assembly 10151 and the second support arm 10132. Under an action of an elastic force of the elastic assembly 10151, the first conjoined cam 10152 abuts against the first support arm 10122 and the second support arm 10132.

In addition, a first cam structure 101411 may be disposed at an end portion that is of the first support arm 10122 and that faces the first conjoined cam 10152, and a second cam structure 101421 may be disposed at an end portion that is of the second support arm 10132 and that faces the first conjoined cam 10152. When the first gear 10141 is disposed on the first support arm 10122, the first cam structure 101411 may be disposed at an end portion of the first gear 10141 in an extension direction of a rotation axis of the first gear 10141. Similarly, when the second gear 10142 is disposed on the second support arm 10132, the second cam structure 101421 may be disposed at an end portion of the second gear 10142 in an extension direction of a rotation axis of the second gear 10142. In addition, a third cam structure 101521 may be disposed at an end portion that is of the first conjoined cam 10152 and that faces the first gear 10141, and a fourth cam structure 101522 is disposed at an end portion that is of the first conjoined cam 10152 and that faces the second gear 10142. In this way, under the action of elastic force of the elastic assembly 10151, the first cam structure 101411 and the third cam structure 101521 that correspond to each other abut against each other, and the second cam structure 101421 and the fourth cam structure 101522 that correspond to each other abut against each other.

It should be noted that, in this application, a cam structure includes a plurality of protrusion portions and a recess portion. When oblique surfaces of protrusion portions of two cam structures are in contact with each other, a damping force that prevents the two cam structures from continuing to rotate relative to each other may be generated between the two cam structures. Based on this, in a process in which the two support arms rotate around the base 1011, the damping assembly 1015 may provide specific damping forces for the two support arms, and the damping forces may be transferred to the first housing fastening bracket 10123 shown in FIG. 13 through the first support arm 10122, and transferred to the second housing fastening bracket 10133 shown in FIG. 13 through the second support arm 10132, so that the damping forces respectively act on the two housings of the electronic device by using the two housing fastening brackets. In this application, the damping assembly 1015 is disposed in the main shaft module 101. This can avoid false unfolding and folding of the electronic device, and can implement suspension of the two housings at specified positions. In addition, a user may have an obvious feeling in a process of unfolding or folding the electronic device. This helps improve user experience.

In a possible embodiment of this application, in addition to being disposed on the first support arm 10122, the first gear 10141 may also be disposed on the first swing arm 10121. Similarly, the second gear 10142 may also be disposed on the second swing arm 10131. In this way, through synchronous rotation of the first swing arm 10121 and the second swing arm 10131, the first housing fastening bracket 10123 and the second housing fastening bracket 10133 synchronously rotate toward or away from each other, and therefore the first housing 2 and the second housing 3 synchronously rotate toward or away from each other. In addition, a first cam structure 101411 is disposed at an end portion of the first gear 10141, and a second cam structure 101421 is disposed at an end portion of the second gear 10142. In this way, in a process in which the first swing arm 10121 and the second swing arm 10131 rotate around the base 1011, the damping assembly 1015 provides specific damping forces for two swing arms, and the damping forces may be transferred to the first housing fastening bracket 10123 through the first swing arm 10121, and transferred to the second housing fastening bracket 10133 through the second swing arm 10131, so that the damping forces respectively act on the two housings of the electronic device by using the two housing fastening brackets.

During specific arrangement of the elastic assembly 10151, the elastic assembly 10151 may include a plurality of springs disposed side by side. In addition, some springs in the elastic assembly 10151 may be sleeved on the first shaft and the second shaft, and the other springs may be sleeved on the intermediate shaft. This helps improve movement stability of the elastic assembly 10151.

Still refer to FIG. 17. The damping assembly 1015 may further include a second conjoined cam 10153, and the elastic assembly 10151 is located between the first conjoined cam 10152 and the second conjoined cam 10153. In addition, the synchronization assembly may further include a third gear 10143 and a fourth gear 10144. The third gear 10143 and the fourth gear 10144 are engaged with each other, and the third gear 10143 and the fourth gear 10144 may be located on a side that is of the second conjoined cam 10153 and that is away from the elastic assembly 10151. It can be seen from FIG. 17 that, in this embodiment of this application, the third gear 10143 and the fourth gear 10144 may be separately sleeved on one intermediate shaft, to improve movement reliability of the third gear 10143 and the fourth gear 10144.

In addition, a fifth cam structure 101431 may be disposed at an end portion that is of the third gear 10143 and that faces the second conjoined cam 10153, and a sixth cam structure 101441 may be disposed at an end portion that is of the second gear 10142 and that faces the second conjoined cam 10153. Further, the second conjoined cam 10153 includes a seventh cam structure and an eighth cam structure (not shown in FIG. 17). In this case, under the action of the elastic force of the elastic assembly 10151, the seventh cam structure and the fifth cam structure 101431 abut against each other, and the eighth cam structure and the sixth cam structure 101441 abut against each other. Cam structures that abut against each other are added to the hinge mechanism 1, so that damping forces in rotation processes of the two support arms may be increased. In this way, the user has a more obvious feeling in an operation process of unfolding or folding the electronic device. This helps improve user experience.

The hinge mechanism 1 provided in the foregoing embodiments of this application may be but is not limited to being used in, for example, the electronic device shown in FIG. 1 or FIG. 2. When the electronic device is in the unfolded state, the base 1011, the first housing 2, and the second housing 3 of the hinge mechanism 1 can provide flat support for the flexible display 4. Because the structure of the hinge mechanism 1 is simple, the hinge mechanism 1 may facilitate simplification of the structure of the electronic device. In addition, the foldable portion of the flexible display 4 is independently supported by the bearing surface 10111 of the base 1011. This can help improve light and shadow effect of the flexible display 4. In a process in which the electronic device rotates around the hinge mechanism 1 from the unfolded state to the folded state, the first housing 2 and the second housing 3 of the electronic device may respectively drive a housing fastening bracket on a corresponding side to rotate around the base 1011, so that the housing fastening bracket may drive, to rotate around the base 1011, a support arm and a swing arm disposed on the same side.

In this way, two sliding grooves of each housing fastening bracket are appropriately designed, so that rotation angles of a support arm and a swing arm on a corresponding side relative to the base 1011 can be adjusted. In this way, when the electronic device is in the folded state, the first arc-shaped rotating block 101211 of the first swing arm 10121 is far away from the flexible display 4, and similarly, the second arc-shaped rotating block 101311 of the second swing arm 10131 is far away from the flexible display 4. In this way, arc-shaped rotating blocks of the two swing arms can be prevented from squeezing or stretching the flexible display 4, to reduce a risk of damage to the flexible display 4, and prolong the service life of the flexible display 4.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device, comprising a first housing, a second housing, a hinge mechanism, and a flexible display, wherein the first housing and the second housing are respectively disposed on two opposite sides of the hinge mechanism, and the first housing and the second housing are rotatably connected to the hinge mechanism;
the flexible display continuously covers the first housing, the second housing, and the hinge mechanism, and the flexible display is fastened to the first housing and the second housing;
the hinge mechanism comprises a base and a main shaft module, the base comprises a bearing surface, the bearing surface is disposed toward the flexible display, the main shaft module comprises a first rotating assembly and a second rotating assembly, and the first rotating assembly and the second rotating assembly are disposed on two opposite sides of the base;
the first rotating assembly comprises a first swing arm and a first housing fastening bracket, the first swing arm has a first plate surface, the first plate surface is disposed toward the flexible display, the first swing arm is rotatably connected to the base, the first swing arm is slidably connected to the first housing fastening bracket, and the first housing fastening bracket is fastened to the first housing;
the second rotating assembly comprises a second swing arm and a second housing fastening bracket, the second swing arm has a second plate surface, the second plate surface is disposed toward the flexible display, the second swing arm is rotatably connected to the base, the second swing arm is slidably connected to the second housing fastening bracket, and the second housing fastening bracket is fastened to the second housing; and
when the electronic device is in an unfolded state, the bearing surface, the first plate surface, and the second plate surface support a foldable portion of the flexible display; and when the electronic device is in a folded state, a screen accommodation space is formed between the first housing fastening bracket, the second housing fastening bracket, and the base, and a foldable portion of the flexible display is accommodated in the screen accommodation space.

2. The electronic device according to claim 1, wherein when the electronic device is in the unfolded state, the bearing surface, the first plate surface, and the second plate surface are flush with each other.

3. The electronic device according to claim 1 or 2, wherein the first housing has a first support surface, the first support surface is configured to support the flexible display, the first housing fastening bracket has a first surface, the first surface is disposed toward the flexible display, and the first support surface is flush with the first surface; and
the second housing has a second support surface, the second support surface is configured to support the flexible display, the second housing fastening bracket has a third surface, the third surface is disposed toward the flexible display, and the second support surface is flush with the third surface.

4. The electronic device according to any one of claims 1 to 3, wherein the first rotating assembly further comprises a first support arm, the first support arm is rotatably connected to the base, and a rotation axis of the first support arm is parallel to and does not coincide with a rotation axis of the first swing arm;
the second rotating assembly further comprises a second support arm, the second support arm is rotatably connected to the base, and a rotation axis of the second support arm is parallel to and does not coincide with a rotation axis of the second swing arm;
a first sliding groove extending in a first direction and a second sliding groove extending in a second direction are provided on the first housing fastening bracket, the first support arm is capable of sliding in the first sliding groove, the first swing arm is capable of sliding in the second sliding groove, a projection of the first direction onto a first cross section is not parallel to a projection of the second direction onto the first cross section, and the first cross section is a reference plane perpendicular to the rotation axis of the first support arm and the rotation axis of the first swing arm; and
a third sliding groove extending in a third direction and a fourth sliding groove extending in a fourth direction are provided on the second housing fastening bracket, the second support arm is capable of sliding in the third sliding groove, the second swing arm is capable of sliding in the fourth sliding groove, a projection of the third direction onto a second cross section is not parallel to a projection of the fourth direction onto the second cross section, and the second cross section is a reference plane perpendicular to the rotation axis of the second support arm and the rotation axis of the second swing arm.

5. The electronic device according to claim 4, wherein the hinge mechanism further comprises a synchronization assembly, and the synchronization assembly comprises a first gear and a second gear that are engaged with each other, wherein the first gear is fastened to an end of the first support arm, the second gear is fastened to an end of the second support arm, the first gear and the first support arm rotate coaxially, and the second gear and the second support arm rotate coaxially; or
the first gear is fastened to an end of the first swing arm, the second gear is fastened to an end of the second swing arm, the first gear and the first swing arm rotate coaxially, and the second gear and the second swing arm rotate coaxially.

6. The electronic device according to claim 5, wherein a first cam structure is disposed at an end portion of the first gear in an extension direction of a rotation axis of the first gear, and a second cam structure is disposed at an end portion of the second gear in an extension direction of a rotation axis of the second gear;
the hinge mechanism further comprises a damping assembly, the damping assembly comprises a first conjoined cam and an elastic assembly, the first conjoined cam is located between the elastic assembly and the first gear, the conjoined cam is located between the elastic assembly and the second gear, and the elastic assembly presses the first conjoined cam toward the first gear and the second gear; and
the first conjoined cam comprises a third cam structure and a fourth cam structure, and under an action of an elastic force of the elastic assembly, the third cam structure abuts against the first cam structure, and the fourth cam structure abuts against the second cam structure.

7. The electronic device according to claim 6, wherein the damping assembly further comprises a second conjoined cam, the elastic assembly is located between the first conjoined cam and the second conjoined cam, the synchronization assembly further comprises a third gear and a fourth gear, the third gear and the fourth gear are engaged with each other, and the third gear and the fourth gear are located on a side that is of the second conjoined cam and that is away from the elastic assembly; and
a fifth cam structure is disposed at an end portion that is of the third gear and that faces the second conjoined cam, a sixth cam structure is disposed at an end portion that is of the second gear and that faces the second conjoined cam, the second conjoined cam comprises a seventh cam structure and an eighth cam structure, and under the action of the elastic force of the elastic assembly, the seventh cam structure abuts against the fifth cam structure, and the eighth cam structure abuts against the sixth cam structure.

8. The electronic device according to any one of claims 1 to 7, wherein a first arc-shaped rotating block is disposed at an end that is of the first swing arm and that is used for a rotatable connection to the base, the base has a first arc-shaped groove, and the first arc-shaped rotating block is accommodated in the first arc-shaped groove and is capable of rotating along an arc-shaped surface of the first arc-shaped groove; and
a second arc-shaped rotating block is disposed at an end that is of the second swing arm and that is used for a rotatable connection to the base, the base has a second arc-shaped groove, and the second arc-shaped rotating block is accommodated in the second arc-shaped groove and is capable of rotating along an arc-shaped surface of the second arc-shaped groove.

9. A hinge mechanism, used in a foldable electronic device, wherein the hinge mechanism is disposed corresponding to a foldable portion of a flexible display of the electronic device, and the hinge mechanism comprises a base and a main shaft module;
the base comprises a bearing surface, the bearing surface is disposed toward the flexible display, the main shaft module comprises a first rotating assembly and a second rotating assembly, and the first rotating assembly and the second rotating assembly are disposed on two opposite sides of the base;
the first rotating assembly comprises a first swing arm and a first housing fastening bracket, the first swing arm has a first plate surface, the first plate surface is disposed toward the flexible display, the first swing arm is rotatably connected to the base, and the first swing arm is slidably connected to the first housing fastening bracket;
the second rotating assembly comprises a second swing arm and a second housing fastening bracket, the second swing arm has a second plate surface, the second plate surface is disposed toward the flexible display, the second swing arm is rotatably connected to the base, and the second swing arm is slidably connected to the second housing fastening bracket; and
when the hinge mechanism is in an unfolded state, the bearing surface, the first plate surface, and the second plate surface support the foldable portion of the flexible display; and when the hinge mechanism is in a folded state, a screen accommodation space is formed between the first housing fastening bracket, the second housing fastening bracket, and the base, and the screen accommodation space is used to accommodate the foldable portion of the flexible display.

10. The hinge mechanism according to claim 9, wherein when the hinge mechanism is in the unfolded state, the bearing surface, the first plate surface, and the second plate surface are flush with each other.

11. The hinge mechanism according to claim 9 or 10, wherein the first housing fastening bracket has a first surface, the second housing fastening bracket has a third surface, and when the hinge mechanism is in the unfolded state, the first surface, the third surface, and the bearing surface are flush with each other.

12. The hinge mechanism according to any one of claims 9 to 11, wherein the first rotating assembly further comprises a first support arm, the first support arm is rotatably connected to the base, and a rotation axis of the first support arm is parallel to and does not coincide with a rotation axis of the first swing arm;
the second rotating assembly further comprises a second support arm, the second support arm is rotatably connected to the base, and a rotation axis of the second support arm is parallel to and does not coincide with a rotation axis of the second swing arm;
a first sliding groove extending in a first direction and a second sliding groove extending in a second direction are provided on the first housing fastening bracket, the first support arm is capable of sliding in the first sliding groove, the first swing arm is capable of sliding in the second sliding groove, a projection of the first direction onto a first cross section is not parallel to a projection of the second direction onto the first cross section, and the first cross section is a reference plane perpendicular to the rotation axis of the first support arm and the rotation axis of the first swing arm; and
a third sliding groove extending in a third direction and a fourth sliding groove extending in a fourth direction are provided on the second housing fastening bracket, the second support arm is capable of sliding in the third sliding groove, the second swing arm is capable of sliding in the fourth sliding groove, a projection of the third direction onto a second cross section is not parallel to a projection of the fourth direction onto the second cross section, and the second cross section is a reference plane perpendicular to the rotation axis of the second support arm and the rotation axis of the second swing arm.

13. The hinge mechanism according to claim 12, wherein the hinge mechanism further comprises a synchronization assembly, and the synchronization assembly comprises a first gear and a second gear that are engaged with each other, wherein the first gear is fastened to an end of the first support arm, the second gear is fastened to an end of the second support arm, the first gear and the first support arm rotate coaxially, and the second gear and the second support arm rotate coaxially; or
the first gear is fastened to an end of the first swing arm, the second gear is fastened to an end of the second swing arm, the first gear and the first swing arm rotate coaxially, and the second gear and the second swing arm rotate coaxially.

14. The hinge mechanism according to claim 13, wherein a first cam structure is disposed at an end portion of the first gear in an extension direction of a rotation axis of the first gear, and a second cam structure is disposed at an end portion of the second gear in an extension direction of a rotation axis of the second gear;
the hinge mechanism further comprises a damping assembly, the damping assembly comprises a first conjoined cam and an elastic assembly, the first conjoined cam is located between the elastic assembly and the first gear, the first conjoined cam is located between the elastic assembly and the second gear, and the elastic assembly presses the first conjoined cam toward the first gear and the second gear; and
the first conjoined cam comprises a third cam structure and a fourth cam structure, and under an action of an elastic force of the elastic assembly, the third cam structure abuts against the first cam structure, and the fourth cam structure abuts against the second cam structure.

15. The hinge mechanism according to claim 14, wherein the damping assembly further comprises a second conjoined cam, the elastic assembly is located between the first conjoined cam and the second conjoined cam, the synchronization assembly further comprises a third gear and a fourth gear, the third gear and the fourth gear are engaged with each other, and the third gear and the fourth gear are located on a side that is of the second conjoined cam and that is away from the elastic assembly; and
a fifth cam structure is disposed at an end portion that is of the third gear and that faces the second conjoined cam, a sixth cam structure is disposed at an end portion that is of the second gear and that faces the second conjoined cam, the second conjoined cam comprises a seventh cam structure and an eighth cam structure, and under the action of the elastic force of the elastic assembly, the seventh cam structure abuts against the fifth cam structure, and the eighth cam structure abuts against the sixth cam structure.

16. The hinge mechanism according to any one of claims 9 to 15, wherein a first arc-shaped rotating block is disposed at an end that is of the first swing arm and that is used for a rotatable connection to the base, the base has a first arc-shaped groove, and the first arc-shaped rotating block is accommodated in the first arc-shaped groove and is capable of rotating along an arc-shaped surface of the first arc-shaped groove; and
a second arc-shaped rotating block is disposed at an end that is of the second swing arm and that is used for a rotatable connection to the base, the base has a second arc-shaped groove, and the second arc-shaped rotating block is accommodated in the second arc-shaped groove and is capable of rotating along an arc-shaped surface of the second arc-shaped groove.
